# EUROPEAN PATENT APPLICATION

(11) **EP 2 299 500 A1**
(43) Date of publication of application: **23.03.2011**
(21) Application number: 09011798.7
(22) Date of filing: 16.09.2009
(51) Int. Cl.: H01L 31/05, H01L 31/18, B21F 23/00, B65H 63/08, B21C 47/24

(54) **Method for operating a stringer and stringer**

(71) Applicant: 3S Industries AG, 3250 Lyss (CH)
(72) Inventor: Schultis, Martin, 79183 Waldkirch (DE); Hirzler, Bernd, 79346 erdingen (DE)
(74) Representative: Fischer, Britta Ruth

(57) **Abstract**

The invention relates to a method for operating a stringer (10), wherein solar cells are connected in series with each other by means of solder ribbon cut-offs, the solder ribbon cut-offs being cut off a continuous solder ribbon strip, the method comprising the steps of monitoring depletion of the momentarily employed continuous solder ribbon strip (13.1) by means of a monitoring unit (16), detecting by means of the monitoring unit (16) when the end (17) of the momentarily employed continuous solder ribbon strip (13.1) approaches, entering a new roll (2) with a new continuous solder ribbon strip (13.2), connecting the end (17) of the momentarily employed continuous solder ribbon strip (13.1) to the new continuous solder ribbon strip (13.2) thereby forming a composed continuous solder ribbon strip with a connection point, moving the composed continuous solder ribbon strip to a cutting station (14), cutting the composed continuous solder ribbon strip into solder ribbon cut-offs in the cutting station (14), and removing the solder ribbon cut-off that comprises the connection point. The invention relates further to a stringer for performing such a method.

## Description

The invention relates to a method for operating a stringer and to a stringer according to the preambles of the independent claims.

In order to manufacture solar modules that can for example be placed on a roof of a building for solar energy generation, several solar cells with bus bars are typically connected in series with each other to form so called strings. For this the bus bars of the solar cells are connected with the bus bars of neighbouring solar cells by means of solder ribbons or solder ribbon cut-offs, respectively. The solder ribbons are typically made of tinned copper and are connected with the bus bars by means of one or more soldering units. A solar cell can have several bus bars, in particular between one to three bus bars, which requires an equal amount of solder ribbon cut-offs for forming a string. The strings are formed in an apparatus called stringer.

After the strings have been formed they are typically transferred to a quality testing station for inspection of the alignment of the solar cells and the solder ribbons as well as for the detection of possible breakage. Then the strings are placed next to each other and cross-linked to obtain a solar cell matrix. The solar cell matrix is then laid sunny side down upon a glass plate with an adhesive layer and covered with a glass or plastics cover with an adhesive layer. Then it is laminated in a laminator for protection purposes.

A stringer for forming a string from solar cells typically comprises among others a feeding stations for supplying solar cells and a continuous solder ribbon strip. The continuous solder ribbon strip is usually uncoiled from a roll that is mounted in the feeding station. For each bus bar of a solar cell there is provided one roll with a continuous solder ribbon strip. After uncoiling, the continuous solder ribbon strip transferred to a cutting station where it is cut into discrete solder ribbon cut-offs whose length is approximately twice the length of a solar cell so that two neighbouring solar cells can be connected with one or more parallel solder ribbon depending on the number of bus bars the solar cell has. The solar cells and the cut solder ribbons (solder ribbon cut-offs) are connected in a soldering station to form the strings which are then aligned and tested for possible breakage.

In general the length of a continuous solder ribbon strip that is coiled up on a roll is not known exactly. Typically length values are in the range of 2 kilometres. When an employed continuous solder ribbon strip is depleted/runs out its end is typically connected by soldering to the free end of a new continuous solder ribbon strip of a new roll that has been entered into the feeding station, thereby forming a composed continuous solder ribbon strip with a connection point. At the connection point the employed and the new continuous solder ribbon strip have been connected by soldering. As the composed continuous solder ribbon strip is thicker at the connection point, the part of the composed continuous solder ribbon strip that comprises the connection point cannot be used for connecting the solar cells. The composed continuous solder ribbon strip is therefore usually drawn by grippers through the stringer until it reaches an exit in the longitudinal direction where the composed continuous solder ribbon strip is cut after the connection point has passed the exit. However, due to the typical length of a stringer a relatively large amount of the continuous solder ribbon strip is lost thereby. For existing stringers approximately 6 metres of the continuous solar ribbon strip are lost per roll in doing so.

It is an object of the invention to provide a method for operating a stringer by which the exploitation of the continuous solder ribbon strip(s) can be improved. It is a further object of the invention to provide a method for operating a stringer by which an employed continuous solder ribbon strip that runs out can be connected to a new continuous solder ribbon strip time-savingly. It is a still further object of the invention to provide a method for operating a stringer by which an employed continuous solder ribbon strip that runs out can be connected to a new continuous solder ribbon strip during running operation of the stringer. It is a still further object of the invention to provide a stringer for performing the method of the invention.

In order to implement these and still further objects of the invention, which will become more readily apparent as the description proceeds, a method for operating a stringer is provided in which depletion of the momentarily employed continuous solder ribbon strip is monitored by means of a monitoring unit, it is detected by means of the monitoring unit when the end of the momentarily employed continuous solder ribbon strip approaches a connecting station, a new roll with a new continuous solder ribbon strip is entered into a feeding station, the end of the momentarily employed continuous solder ribbon strip is connected to the new continuous solder ribbon strip, in particular to the free end of the new continuous solder ribbon strip, within the connecting station thereby forming a composed continuous solder ribbon strip with a connection point, the composed continuous solder ribbon strip is, in particular clockedly, moved to a cutting station, the composed continuous solder ribbon strip is cut into single/discrete solder ribbon cut-offs (also called: solder ribbons) in the cutting station, and the single/discrete solder ribbon cut-off that comprises the connection point is removed. The connecting station does not necessarily need to be a separate physical unit, but can be any point in the production line at which the connection of the momentarily employed continuous solder ribbon strip to te new continuous solder ribbon strip takes place.

In the following the term "solder ribbon cut-off" is for simplicity used instead of "single/discrete solder ribbon cut-off". The connection point of the composed continuous solder ribbon strip is that point at which the end of the momentarily employed continuous solder ribbon strip is connected with the new continuous solder ribbon strip or its free end, respectively.

For forming the composed continuous solder ribbon strip, the end of the momentarily employed continuous solder ribbon strip may be connected to the new continuous solder ribbon strip (in particular its free end) for example by soldering, welding such as e.g. cold pressure welding, gluing (in particular by means of conducting adhesive), processes for forming compression joints such as e.g. cold pressing, warm pressing or hot pressing, forming a crimp connection, riveting (also cold riveting), splicing and/or by any other apt way for forming an appropriate connection, with the connecting station being construed accordingly.

The stringer according to the invention comprises a feeding station for supplying a continuous solder ribbon strip, in which in particular a roll of a continuous solder ribbon strip is uncoiled in operation, a cutting station for cutting the continuous solder ribbon strip into solder ribbon cut-offs, a monitoring unit for monitoring depletion of the momentarily employed continuous solder ribbon strip, a connecting station for connecting the end of the momentarily employed continuous solder ribbon strip to the new continuous solder ribbon strip by soldering to form a composed continuous solder ribbon strip with a connection point, and removing means for removing a solder ribbon cut-off that comprises the connection point. The removing means for removing the solder ribbon cut-off(s) that comprises the connection point are preferably given by grippers, in particular by those grippers that are already provided in the stringer for movement of the solder ribbon cut-offs from the cutting station to the soldering station.

The entering of the new roll with a new continuous solder ribbon strip takes in particular place manually, but can also take place automatically if a automatically fed feeding station is provided. Moving the composed continuous solder ribbon strip after it has been formed in the connecting station can be either initiated manually, e.g. by a staff member pressing a corresponding button on the stringer (also called half-automatic operation), or automatically when it is automatically detected, e.g. by the monitoring unit, that the connection is completed (also called fully automatic operation). If the connecting of the end of the momentarily employed continuous solder ribbon strip and the new continuous solder ribbon strip takes place during running operation, then no additional initiation of the moving is required. The composed continuous solder ribbon strip is then automatically moved with the next operating step (also called fully automatic operation).

The connecting station comprises preferably a holder for the ends of the momentarily employed continuous solder ribbon strip and the new continuous solder ribbon strip that shall be connected and a soldering unit with a soldering tip for connecting these ends.

The method and the stringer according to the invention have the advantage that that part of the composed continuous solder ribbon strip that comprises the connection point can be easily and time-savingly removed with waste of relatively little of the composed continuous solder ribbon strip.

In a preferred embodiment of the invention a surveillance unit is provided downstream the cutting station for monitoring the cut solder ribbon cut-offs to detect solder ribbon cut-offs that comprise a connection point. The cutting station is preferentially given by camera, in particular a three-dimensional camera. The detected solder ribbon cut-offs that comprise a connection point are then removed by the removing means. A control unit is provided for controlling the removing means in dependence on the output signal of the surveillance unit.

In a further preferred embodiment of the invention a control unit is provided, wherein the number of production steps from the connecting station to the cutting station is known and stored in the control unit. After the composed continuous solder ribbon strip has been formed in the connecting station and has been moved by the number of production steps from the connecting station to the cutting station plus by one additional step, then that solder ribbon cut-off that comprises the connecting point has just been cut off the composed continuous solder ribbon strip by the cutting station and the removing means are controlled such by the control unit that that particular solder ribbon cut-off is removed.

In a further preferred embodiment of the invention a control unit is provided, wherein the distance from the connecting station to the cutting station is known and stored in the control unit. After the composed continuous solder ribbon strip has been formed in the connecting station and has been moved by the known distance from the connecting station to the cutting station, then that part of the composed solder ribbon strip that comprises the connecting point will be cut next by the cutting station. Then the removing means are controlled such by the control unit that the solder ribbon cut-off that is cut next is removed after it has been cut.

The monitoring unit is preferably designed such that it triggers an alarm when the monitoring unit detects that the end of the momentarily employed continuous solder ribbon strip is approaching. The alarm is preferably triggered a certain predefined amount of time, e.g. 5 minutes, before the end of the momentarily employed continuous solder ribbon strip enters the connecting station. Triggering the alarm a certain amount of time before the momentarily employed continuous solder ribbon strip ends leaves the staff advantageously with enough time to insert a new roll with a new continuous solder ribbon strip into the feeding station, so that connection of the end of the momentarily employed continuous solder ribbon strip with the new continuous solder ribbon strip can take place during running operation with no need for stopping the operation of the stringer (fully automatic operation).

The above described preferred embodiments can be employed separately or in all possible combinations with each other.

Further advantageous features and applications of the invention can be found in the dependent claims as well as in the following description of the drawings illustrating the invention. In the drawings like reference signs designate the same or similar parts throughout the several figures of which:
Fig. 1 shows a flow chart of the method according to the invention, and
Fig. 2 schematically shows a partial side view of a stringer according to the invention.

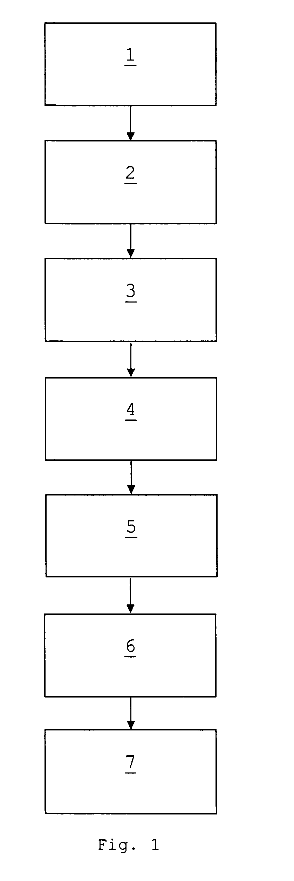

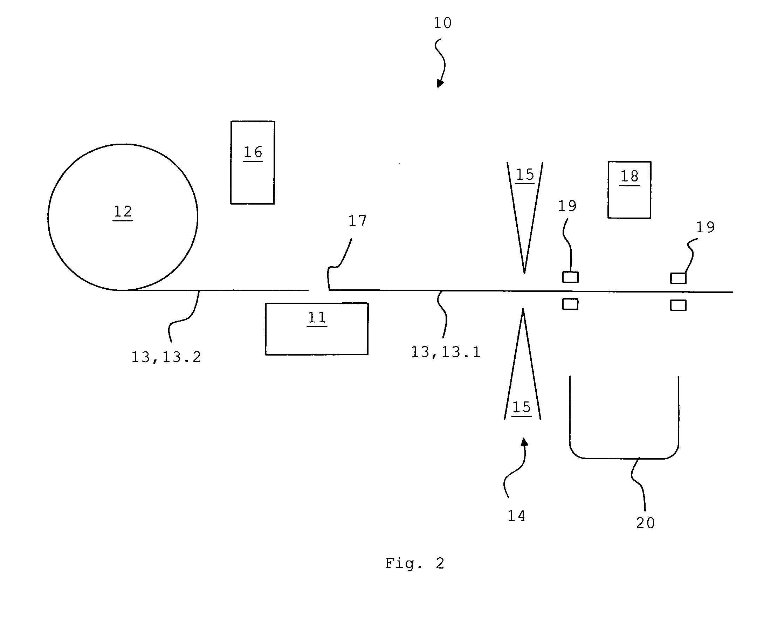

Figure 1 shows a flow chart of the method of the invention. Figure 2 schematically shows part of a stringer 10 for performing the method of the invention. Soldering station for connecting the solder ribbon cut-offs with the solar cells and testing stations are for example not shown for simplicity. The stringer 10 comprises a feeding station (not shown in detail) that is fed with a roll 12 onto which a continuous solder ribbon strip 13 is coiled. The continuous solder ribbon strip 13 is uncoiled from the roll 12 and drawn via a connecting station 11 to a cutting station 14 with cutters 15 for cutting the continuous solder ribbon strip 13 into solder ribbon cut-offs. Figure 2 shows the continuous solder ribbon strip 13 being drawn beyond the cutting station 14 before a solder ribbon cut-off has been cut from it by the cutters 15.

The depletion of the momentarily employed continuous solder ribbon strip 13.1 is monitored by a monitoring unit 16 in step 1 of the method of the invention. When the monitoring unit 16 in step 2 of the method of the invention detects that the end 17 of the momentarily employed continuous solder ribbon strip 13.1 approaches the connecting station 11, it preferably triggers an alarm a certain predefined amount of time before the momentarily employed solder ribbon strip 13.1 actually enters the connecting station 11, to inform the staff that a new roll 2 with a new continuous solder ribbon strip 13.2 has to be inserted into the feeding station. After a new roll 12 has been entered into the feeding station in step 3, the new continuous solder ribbon strip 13.2 is drawn by grippers (not shown) to the connecting station 11.

In the connecting station 11 the end 17 of the momentarily employed continuous solder ribbon strip 13.1 is connected to the free end of the new continuous solder ribbon strip 13.2 by means of a soldering unit (not shown) to form a composed continuous solder ribbon strip that comprises the connection point (step 4) where two solder ribbon strips 13.1, 13.2 have been connected. In step 5 the composed continuous solder ribbon strip is stretched and moved, in particular clockedly, by grippers (not shown) to the cutting station 14. This move can be initiated manually or automatically as described above, or it can occur within a normal operating step during running operation.

The cutters 15 of the cutting station 14 cut a solder ribbon cut-off from the composed continuous solder ribbon strip in step 6. In the direction of movement after the cutters 15 there is preferably provided a surveillance unit 18 in form of a camera for monitoring the cut solder ribbon cut-offs for a connection point. When the surveillance unit 18 detects a connection point in a solder ribbon cut-off, it sends a corresponding signal to a control unit (not shown). The control unit then sends a control signal to the grippers 19 that hold that particular solder ribbon cut-off after it left the cutting station 14 to control the grippers 19 such that they in step 7 of the method according to the invention remove the solder ribbon cut-off with the connection point from the flow of solder ribbon cut-offs and dispose that solder ribbon cut-off in a waste container 20. From the waste container 20 the disposed solder ribbon cut-offs are preferably transferred to a discharging unit (not shown) that is preferentially located outside the stringer 10.

## Claims

1. A method for operating a stringer (10), wherein solar cells are connected in series with each other by means of solder ribbon cut-offs, the solder ribbon cut-offs being cut off a continuous solder ribbon strip (13), **characterized by** the following steps:
- monitoring depletion of the momentarily employed continuous solder ribbon strip (13.1) by means of a monitoring unit (16),
- detecting by means of the monitoring unit (16) when the end (17) of the momentarily employed continuous solder ribbon strip (13.1) approaches,
- entering a new roll (2) with a new continuous solder ribbon strip (13.2),
- connecting the end (17) of the momentarily employed continuous solder ribbon strip (13.1) to the new continuous solder ribbon strip (13.2) within a connecting station (11) thereby forming a composed continuous solder ribbon strip with a connection point,
- moving the composed continuous solder ribbon strip to a cutting station (14),
- cutting the composed continuous solder ribbon strip into solder ribbon cut-offs in the cutting station (14), and
- removing the solder ribbon cut-offs that comprises the connection point.

2. The method according to claim 1, wherein after the cutting the solder ribbon cut-offs are monitored by a surveillance unit (18) to detect solder ribbon cut-offs that comprise a connection point, and wherein a solder ribbon cut-offs is removed upon detection that it comprises a connection point.

3. The method according to claim 1, wherein the number of production steps from the connecting station (11) to the cutting station (14) is stored in a control unit, wherein the composed continuous solder ribbon strip is formed and moved by the number of production steps from the connecting station (11) to the cutting station (14) plus by one additional production step, and wherein after that the solder ribbon cut-off that has just been cut is removed.

4. The method according to claim 1, wherein the distance from the connecting station (11) to the cutting station (14) is stored in a control unit, wherein the composed continuous solder ribbon strip is formed and moved by the distance from the connecting station (11) to the cutting station (14), and wherein the next but one solder ribbon cut-off that is cut is removed.

5. The method according to one of the preceding claims, wherein an alarm is triggered by the monitoring unit (16) when the monitoring unit (16) detects that the end (17) of the momentarily employed continuous solder ribbon strip (13.1) is approaching.

6. The method according to claim 5, wherein the alarm is triggered a certain amount of time before the end (17) of the momentarily employed continuous solder ribbon strip (13.1) enters the connecting station (11).

7. A stringer for performing a method according to one of the preceding claims, comprising a feeding station for supplying a continuous solder ribbon strip (13) and a cutting station (14) for cutting the continuous solder ribbon strip (13) into solder ribbon cut-offs, **characterized by** a monitoring unit (16) for monitoring depletion of the momentarily employed continuous solder ribbon strip (13.1), a connecting station (11) for connecting the end (17) of the momentarily employed continuous solder ribbon strip (13.1) to the new continuous solder ribbon strip (13.2) to form a composed continuous solder ribbon strip with a connection point, and removing means (19) for removing a solder ribbon cut-off that comprises the connection point.

8. The stringer according to claim 7, wherein the removing means for removing a solder ribbon cut-off that comprises the connection point comprises grippers (19).

9. The stringer according to claim 7 or 8, wherein a waste container (20) is provided for collecting the removed solder ribbon cut-offs.

10. The stringer according to one of the claims 7 to 9, wherein the monitoring unit (16) is constructed such that it triggers an alarm when it detects that the end (17) of the momentarily employed continuous solder ribbon strip (13.1) is approaching.

11. The stringer according to claim 10,
wherein the monitoring unit (16) is constructed such that the alarm is triggered a certain amount of time before the end (17) of the momentarily employed continuous solder ribbon strip (13.1) enters the connecting station (11).

12. The stringer according to one of the claims 7 to 11, wherein a surveillance unit (18) is provided for monitoring the cut solder ribbon cut-offs to detect solder ribbon cut-offs that comprise a connection point.

13. The stringer according to one of the claims 7 to 12, wherein a control unit is provided with the number of production steps from the connecting station (11) to the cutting station (14) and/or the distance from the connecting station (11) to the cutting station (14) being stored in the control unit, and wherein the removing means (19) are controllable by the control unit.
